# EUROPÄISCHE PATENTSCHRIFT

(11) **EP 1 453 091 B1**
(45) Veröffentlichungstag und Bekanntmachung des Hinweises auf die Patenterteilung: **13.12.2006**
(21) Anmeldenummer: 04090067.2
(22) Anmeldetag: 25.02.2004
(51) Int. Cl.: H01L 23/498, H01L 23/15

(54) **Keramische Mehrlagenplatte mit monolithischem Schichtaufbau und Verfahren zu ihrer Herstellung**
Ceramic multilayer board with monolithic layer structure and method for the production thereof
Plaque céramique multicouche avec arrangement de couches monolithique et sa méthode de fabrication

(30) Priorität: 27.02.2003 DE 10309689
(43) Veröffentlichungstag der Anmeldung: 01.09.2004
(73) Patentinhaber: BAM Bundesanstalt für Materialforschung und -prüfung, 12205 Berlin (DE); W.C. Heraeus GmbH, 63450 Hanau (DE); Siegert TFT GmbH, 07629 Hermsdorf (DE); VIA electronic GmbH, 07629 Hermsdorf (DE)
(72) Erfinder: Schiller, Wolfgang, 12557 Berlin (DE); Gemeinert, Marion, 12683 Berlin (DE); Ulrich, Fritz, 13156 Berlin (DE); Kuchenbecker, Petra, 13158 Berlin (DE); Brode, Wolfgang, 07629 Hermsdorf (DE); Bechtold, Franz, 91056 Erlangen (DE); Modes, Christina, 60439 Frankfurt/Main (DE)
(74) Vertreter: Walter, Wolf-Jürgen

(56) Entgegenhaltungen:
- WO-A-02/18285
- WO-A1-00/04577
- DE-A- 10 038 429
- DE-A- 10 130 893
- US-A- 4 221 047
- US-A- 4 642 148
- US-A- 5 277 723
- DERNOVSEK O ET AL: "LTCC glass-ceramic composites for microwave application" JOURNAL OF THE EUROPEAN CERAMIC SOCIETY, ELSEVIER SCIENCE PUBLISHERS, BARKING, ESSEX, GB, VOL. 21, NR. 10-11, PAGE(S) 1693-1697 , XP004301752 ISSN: 0955-2219 * Zusammenfassung; Abbildung 2 *
- A. JILLAVENKATESA, ST.J. DAPKUNAS, L.-S. H. LIEN: "NIST Recommended Practice Guide : Particle Size Characterization" Januar 2001 (2001-01), NATIONAL INSITUTE OF STANDARDS AND TECHNOLOGY , WASHINGTON * Seiten 135,131 *
- W. HINZ: "Silicat Lexicon" 1985, AKADEMIE VERLAG , BERLIN * Seite 226 *
- W. HINZ: "Silikate" 1969, VEB VERLAG FÜR BAUWESEN , BERLIN * Seite 177 - Seite 178 * * Seite 180 *

## Beschreibung

Die Erfindung betrifft einen keramischen Körper in Form einer Mehrlagenplatte mit einem monolithischen Mehrschichtaufbau nach einer modifizierten LTCC-Multilayer-Technologie als Verdrahtungsträger für passive und aktive elektronische Bauelemente sowie ein Verfahren zur Herstellung einer solchen keramischen Mehrlagenplatte, wobei die Mehrlagenplatte für hochauflösende Beschichtungen, vorzugsweise mittels Dünnfilmtechnik oder Feinstlinien-Dickschichttechnik, geeignet sein soll.

Ein Entwicklungsziel in der Hybrid-Mikroelektronik und Mikrosystemtechnik ist die fortschreitende Miniaturisierung hochintegrierter Baugruppen durch Anwendung neuer effizienter Techniken.

Glaskeramische Komposit-Werkstoffe in Form von Gießfolien erlangen hier zunehmend an Bedeutung, da es mit ihrer Hilfe gelingt, ein hermetisch dichtes Packaging von Mikrokomponenten, z. B. aktiven und passiven elektronischen Bauelementen sowie Sensorelementen einschließlich deren elektrische Verbindung zu realisieren. Grund dafür ist vor allem die Eignung dieser Gießfolien für die sogenannte LTCC- Multilayer-Technologie (LTCC= Low Temperature Co-fired Ceramic).

Die LTCC-Technologie umfasst folgende Verfahrensschritte:
- Herstellung einer keramischen Grünfolie, die organischen Binder und weitere organische Hilfsstoffe enthält
- Stanzen der Folienteile und der Durchkontaktierungslöcher
- Bedrucken der Grünfolien mit elektrischen Leiterbahn-strukturen und Befüllen der Durchkontaktierungslöcher (jeweils mittels Metallisierungspasten)
- Übereinanderstapeln der metallisierten Folien und Laminieren zu einem Schichtverbund
- Ausbrennen der organischen Hilfsstoffe (Entbindern) und Sintern (Co-firing) zu einem monolithischen Schichtverbund.

Die in den Folien verarbeiteten glaskeramischen Komposit-werkstoffe müssen eine Sintertemperatur unterhalb der Schmelz-punkte der im Co-firing eingesetzten Leiterbahn-Metalle aufwei-sen, z.B. für Silber (Schmelzpunkt: 962 °C) unterhalb 950 °C.

Bei der klassischen LTCC-Technologie tritt beim Sintern des Schichtverbundes eine laterale Schwindung von 12 bis 20 % mit einer Schwindungstoleranz von 0,2 bis 1% auf ("unconstrained sintering" bzw. "freies" Sintern). Für die präzise und zuverlässige Gestaltung der dreidimensionalen Leiterbahnstrukturen in Feinlinientechnik in Verbindung mit einer Nutzenfertigung im Großformat (≥ 6 x 6 Zoll) und der Flip-Chip-Technik zur Aufbringung der Halbleiterbauelemente auf die Oberfläche des gesinterten monolithischen Schichtverbundes (Substrat) ist es erforderlich, dass die laterale Schwindung reduziert wird, um die geforderten geringen Schwindungstoleranzen einhalten zu können.

Es sind Techniken bekannt, bei denen der Schichtverbund in lateraler Richtung wesentlich geringer schwindet als in axialer Richtung. Beispielsweise erfolgt ein Co-firing von Laminaten aus keramischen Folien verschiedener Zusammensetzung, bei denen die äußeren Folienlagen nicht sintern. Das nicht sinternde Material haftet aufgrund der Laminierung und einer partiellen Interdiffusion fest an dem sinternden und verhindert dadurch die laterale Schwindung ("constrained sintering" bzw. "zero-x/y-shrinkage"). Die Schwindung der inneren Schichten findet deshalb nur in axialer Richtung statt. Allerdings muss die ungesinterte Lage anschließend in einer Nachbearbeitung entfernt werden ("Opferfolienprinzip" gemäß US 5,474,741).

Eine weitere Möglichkeit, die laterale Schwindung zu unterdrücken, besteht darin, während des Sinterns einen Druck in axialer Richtung auf den Schichtverbund auszuüben, was einen hohen technischen Aufwand bedeutet und eine jeweilige Anpassung des Druck-Temperatur-Regimes an das Sinterverhalten der verwendeten Werkstoffe erfordert (US 4,585,706). Auch die Kombination von Opferfolien mit Drucksintern ist bekannt.

Andere Verfahren integrieren mehrere schwindungshemmende Folienlagen in den Schichtverbund, wobei diese entweder porös bleiben oder durch ein speziell zugesetztes Glas und aus den Basislagen eindiffundierende Bestandteile verdichten sollen.

Tamaki et al. (JP 06-172017) beschreiben den Aufbau eines Laminates aus zwei Folientypen unterschiedlicher Zusammensetzung mit verschiedenen Sintertemperaturen und weisen nach, dass mit steigender Differenz der Sintertemperaturen die laterale Schwindung des Verbundes abnimmt.

Aus der DE 19831821 ist ein Laminat aus zwei Folientypen bekannt zur Integration von passiven elektrischen Bauelementen. Nachteilig hierbei ist, dass zunächst die äußeren Basislagen dicht sintern und erst danach die inneren Funktionsschichten. Dadurch ist der notwendige Gasaustritt aus den Poren der Innenlagen sehr erschwert und führt zu hohen Restporositäten der Schichtverbunde.

Allen o. g. Schriften, die verschiedene Varianten der zero-x/y-shrinkage-Technik betreffen, ist gemeinsam, dass sie keine technische Lehre enthalten, auf welchem Wege eine Substratoberfläche mit geringer Rauheit erreichbar und für eine hochauflösende Beschichtungstechnik geeignet wäre. Über die chemische Resistenz der Substratoberflächen, die gleichermaßen für eine Dünnfilmprozessierung wichtig ist, wird ebenfalls keine Aussage getroffen.

Die elektrische, dreidimensionale Verbindung der aktiven und passiven Bauelemente ist nach dem Stand der Technik durch siebdrucktechnische Aufbringung von Feinleiterbahnen und von Durchkontaktierungen aus Metallen hoher elektrischer Leitfähigkeit, wie Gold und Silber, in einem Brand möglich. Mit der Erhöhung des Integrationsgrades der aktiven elektronischen Bauelemente besteht die Notwendigkeit, die Leiterzugbreite weiter zu reduzieren. Gleichzeitig steigen die Anforderungen an die Oberflächengüte der Leiterbahnen, um insbesondere die Verluste bei hohen Frequenzen zu reduzieren.

Bekannt sind Verfahren, bei denen die hohe Oberflächengüte des Substrates durch eine nach der abgeschlossenen Sinterung der LTCC-Keramiken durchgeführte aufwändige mechanische Nachbearbeitung (Schleifen und Polieren) erzeugt wird und die Leiterbahnen in Dünnfilmtechnik oder in ähnlicher Feinstrukturierung ausgeführt sind. Gleichzeitig besteht dadurch die Möglichkeit, auch andere funktionelle Strukturen in Dünnfilmtechnik aufzubringen. Die Kosten der mechanischen Bearbeitung sind allerdings beträchtlich und das unterschiedliche Abtragungsverhalten von Keramik und Metall (Durchkontaktierungen) an der Oberfläche bereitet zusätzliche Probleme. Die chemische Resistenz der so behandelten Oberfläche ist außerdem für chemische Prozesse wie in der Dünnfilmtechnik üblich unzureichend. Da die betreffenden LTCC-Substrate durch "freies" Sintern hergestellt wurden, genügen sie auch nicht den eingangs erwähnten Toleranzforderungen.

Andere technische Lösungen, indem ein Fenster in die oberste Folienlage eingebracht und dieses mit einer Glaspaste gefüllt wird, welche nach dem Co-firing die für die Dünnfilmtechnik erforderlichen geringen Rauheiten aufweist, benötigen zusätzliche Prozessschritte, und es ergeben sich Einschränkungen für das Schaltungsdesign. Außerdem bildet die zwischen der Glasfläche und der restlichen Substratoberfläche entstehende Kante, über welche die Anschlussmetallisierungen zu den Dünnfilmstrukturen verlaufen müssen, eine mögliche Fehlerquelle.

Aus WO 02/18285 ist eine Glaskeramikmasse für die Mikrowellentechnik bekannt, bestehend aus einer Oxidkeramik und einem Glasmaterial in einem Schichtaufbau, wobei die Schichten einheitlich bei <850°C kristallisiert werden. Die DE 100 38 429 beschreibt ein Verbundlaminat mit einer mittigen Glasschicht, die beim Schmelzen in die äußere Schicht aus Keramikteilchen eindringen kann. In der US 4 642 148 wird eine keramische Mehrlagenplatte über zwei Vorerhitzungsstufen auf > 900°C bis vor den Schmelzpunkt von Kupfer und dann Sintern des glaskeramischen Materials erhitzt. Die US 5 277 723 betrifft ein Herstellungsverfahren eines keramischen Mehrlagenkörpers durch Brennen des Laminats unter Druck und über Ausbildung konvexer Ränder. Aus DE 101 30 893 ist eine Glaskeramik mit einem variablen Ausdehnungskoeffizienten von 9-13 ppm/K und mit Außenschichten aus Keramik bekannt. In J. Eur. Ceramic Soc. 21 (2001) 1693-97 werden Komposite des Systems BaO-Nd₂O₃-TiO₂ beschrieben, die mit Lanthan-Borat-Titanat-Gläsern bei > 900°C dichtsintern und für die Mikrowellentechnik einsetzbar sind.

Aufgabe der Erfindung ist es, einen keramischen Mehrschichtverbund (Mehrlagenplatte) mit geringer lateraler Schwindung und geringer lateraler Schwindungstoleranz bereitzustellen und gleichzeitig wenigstens eine ebene und glatte Oberfläche des fertig gesinterten keramischen Körpers zu erzielen, die für hochauflösende Beschichtungen, vorzugsweise mittels Dünnfilmtechnik oder Feinstlinien-Dickschichttechnik geeignet ist, wobei die genannten Nachteile des Standes der Technik vermieden werden. Eine weitere Aufgabe besteht in der Bereitstellung eines entsprechenden Herstellungsverfahrens für einen solchen Verbund.

Erfindungsgemäß ist die keramische Mehrlagenplatte (im folgenden auch: keramischer Körper), bestehend aus Innenlagen mit Leiterstrukturen und mit Durchkontaktierungen versehenen Außenlagen, wobei der Verbund durch Sintern von keramischen Grünfolien mit unterschiedlicher keramischer Zusammensetzung hergestellt wird, durch ein Verfarhen nach Anspruch 1
und dabei eine röntgenamorphe glasige Struktur auf zumindest einer Außenfläche bilden mit einem Mittenrauhwert Rₐ von 0,05-0,25 µm und in den Außenlagen eine Porengröße D₅₀ von <2 µm und einen Gehalt an restlichen Poren nach dem Sintern von <0,3 %, wobei der Porengrößenwert ein Medianwert der Porengrößenverteilung ist,
und die Mehrlagenplatte eine laterale Schwindung des Schichtverbundes von 0,01 bis 2 % aufweist bei einer Schwindungstoleranz von nicht mehr als 0, 1 %.

Die Außenfläche wenigstens einer der beiden äußeren Schichten weist eine glasige, röntgenamorphe Struktur auf. Die innere(n) Schicht(en) haben im gesinterten Zustand eine kristalline Struktur.

Zum besseren Verständnis der Erfindung dienen die folgenden Definitionen. Unter D₅₀ wird der Medianwert der Partikel- bzw. Porengrößenverteilung verstanden. Die minimale Schwindungstoleranz ist der dreifache Wert der Standardabweichung σ der lateralen Schwindung (x,y-Schwindung). Die Sintertemperatur T_{S} ist die Dichtbrandtemperatur, d.h. diejenige Temperatur, die bei einer Haltedauer von 10 min zu einem dichten Körper mit einer Restporosität < 15 % führt. Unter Mittenrauhwert Rₐ ist der nach dem Brennen des Schichtverbundes bei T_{S} durch Messungen mit einem Tastschnittgerät ermittelte mittlere Wert von 10 Messungen gemäß DIN EN ISO 4288 von 4/1998 zu verstehen.

Ein bevorzugter keramischer Körper hat einen Mittenrauhwert Rₐ nach dem Sintern von 0,05-0,15 µm auf zumindest einer Außenfläche.

Ein bevorzugter keramischer Körper hat eine laterale Schwindung (x/y-Schwindung) des Schichtverbundes von 0,01-0,5 % und eine Schwindungstoleranz von nicht mehr als 0,1 %, bevorzugt nicht mehr als 0,04 %.

Weiterhin ist bevorzugt, dass die äußere(n) Schicht(en) des keramische Körpers einen Gehalt an restlichen Poren von gleich oder kleiner 0,3 % und eine Porengröße <1,2 µm aufweist.

Bevorzugte Glaspulver für die Bildung des keramischen Körpers sind aus der Gruppe ausgewählt, bestehend aus Alkali-Borosilicatgläsern Me₂^{I}O-B₂O₃-SiO₂, Alumo-Borosilicatgläsern Me^{II}O-Al₂O₃-B₂O₃-SiO₂, Alumosilicatgläsern Me^{II}O-Al₂O₃-SiO₂, Lanthan-Borat-Titanat-Gläsern (Me^{II}O)-La₂O₃-B₂O₃-TiO₂ und Erdalkali-Lanthan-Borat-Gläsern (Me₂^{I}O)-Me^{II}O-La₂O₃-B₂O₃, worin Me^{I} = Li, Na, K und Gemische davon, sowie Me^{II} = Mg, Ca, Sr, Ba, Zn und Gemische davon sind, und Gemische der Gläser.

Die eingesetzten keramischen Pulver sind vorzugsweise ausgewählt unter oxidischen Stoffen, nitridischen Stoffen oder Gemischen davon, vorzugsweise unter kristallinen Stoffen wie
Al₂O₃, AlN, Mg₂SiO₄, SiO₂, TiO₂, Zn₂SiO₄, ZrO₂, ZrSiO₄, Celsian, Mullit, Spodumen, Titanaten, Zirkonaten und Gemischen davon.

Besonders bevorzugt sind Al₂O₃, SiO₂, Mg₂SiO₄, Zn₂SiO₄, ZrSiO₄, Mullit, und Calciumtitanat und Gemische davon.

Die metallischen Leiterbahnen sind vorzugsweise aus Silber; dabei sind Zulegierungen z.B. von Pd und/oder Pt bis maximal 20 Gew-% möglich. Weiterhin sind Kombinationen von Ag (innere Leiterbahnen) und Au (äußere Leiterbahnen) möglich.

Überraschenderweise wurde gefunden, dass bei einem keramischen Schichtverbund aus keramischen Grünfolien deutliche Verbesserungen dabei erzielt werden, wenn die Folien im Inneren bei einer niedrigeren Temperatur sintern als die äußeren und die Glasphase nach dem Dichtsintern kristallisiert. Die äußeren Schichten sintern bei einer zweiten, höheren Temperatur dicht. Dadurch wird zum einen die laterale Schwindung des Schichtverbundes weitgehend unterdrückt, und es kann ein Körper mit geringen lateralen Schwindungstoleranzen < 0,1 % erzeugt werden.

Die Sintertemperaturen der inneren und der äußeren Schichten unterscheiden sich vorzugsweise um wenigstens 50 K, besonders bevorzugt um wenigstens 100 K.

Die Komposit-Bestandteile für die äußere Schicht (Lage) werden so aufbereitet, dass ihre Partikelgrößen in der keramischen Gießfolie unter 3 µm vorliegen. Die Glasphase dieser äußeren Lage kristallisiert bis zum Abschluss des gesamten Brennprozesses nicht aus und bleibt auch beim Abkühlen der Sinterprodukte glasig. Dadurch werden in den äußeren Lagen ein nahezu porenfreies, feinkörniges Dispersphase/Matrix-Gefüge und auf der Oberfläche eine glasige Brennhaut mit sehr geringer Oberflächenrauheit ausgebildet. Diese glatte Oberfläche kann für eine direkte Aufbringung von Funktionsstrukturen mittels hochauflösender Beschichtung, vorzugsweise mittels mittels Dünnfilmtechnik oder Feinstlinien-Dickschichttechnik, genutzt werden, ohne den fertig gesinterten Körper vorher einer mechanischen Oberflächenbehandlung unterziehen zu müssen.

Gegenstand der Erfindung ist ein Verfahren zur Herstellung eines keramischen Körpers (Mehrlagenplatte) nach Anspruch 1.

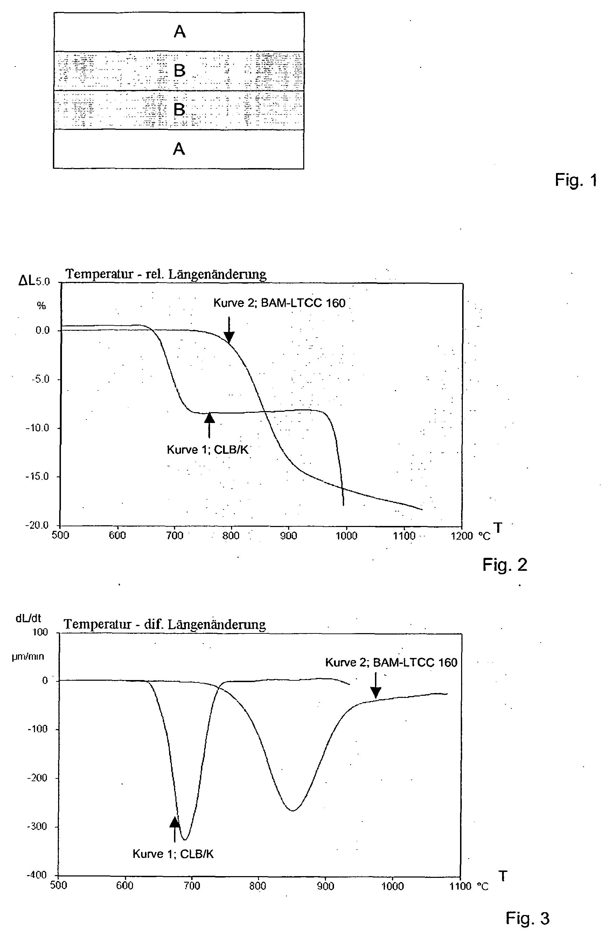

Das Verfahren arbeitet unter Verwendung von keramischen Gießfolien A (Bezeichnung siehe Fig. 1), die ein Kompositpulver A enthalten, welches ein kristallines/keramisches Material und ein kristallisationsfestes, chemisch resistentes Glas umfaßt. Dadurch tritt bei der Gießfolie A nach ihrem Dichtsintern eine Kristallisation der Glasphase A nicht auf. Es bildet sich eine dichte, glatte, glasurartige Brennhaut, die eine hohe chemische Resistenz aufweist.

Die Gießfolie B besteht aus einem Kompositpulver B, welches ein kristallines/keramisches Material und ein gezielt kristallisierbares Glas B umfasst. Die Gießfolie B zeigt nach ihrem Dichtsintern eine weitgehende Kristallisation der Glasphase B.

Die Grünfolien werden aus einem Schlicker hergestellt, der ein verschlickertes Rohstoffgemenge aus vorzugsweise 60 bis 90 Vol-% eines Glaspulvers und vorzugsweise 10-40 Vol-% eines keramischen Pulvers für die o.g. ersten Folien a) umfasst. Für die Folien b) wird ein verschlickertes Rohstoffgemenge aus 40-70 Vol-% Glaspulver und 30-60 Vol-% keramisches Pulver eingesetzt. Auch weitere Zuschlagstoffe wie Farbstoffe können enthalten sein sowie Keimbildner für die kristallisierenden Folien B.

Nach dem Formstanzen der Folien A und B einschließlich der Durchkontaktierungslöcher (vias) erfolgt die Metallisierung der grünen Folien A und B durch Füllen der vias und Siebdruck der Leiterbahnen. Anschließend erfolgt das Stapeln der Gießfolien, wobei die "kristallisierenden" Folien B in der Mitte des Stapels platziert werden, die Folien A die Außenlagen bilden und der Folienstapel vorzugsweise symmetrisch aufgebaut wird. Der Stapel wird dann zu einem Schichtverbund laminiert und die organischen Hilfsstoffe bei Temperaturen < 600 °C ausgetrieben (Entbindern). Danach erfolgt das Brennen des Schichtverbundes bei der Sintertemperatur von 650 bis 800 °C, was zur Dichtsinterung der inneren Schichten B und zur Kristallisation der Glasphase B in dieser Schicht führt. Dabei erfolgt überraschend eine Schwindung nahezu nur in axialer Richtung. Die folgende weitere Temperaturerhöhung bis zur Sintertemperatur von 800-900 °C führt zu einer voranschreitenden Kristallisation der Glasphase B.

Das Brennen des Schichtverbundes bei der höheren Sintertemperatur von 800-900 °C führt zur Dichtsinterung der äußeren Lagen, wobei die Glasphase der äußeren Lagen auch nach dem anschließenden Abkühlen der Sinterprodukte *nicht* kristallisiert und eine glatte Brennhaut auf der Oberfläche des Schichtverbundes ausgebildet wird, die überraschenderweise eine so hohe Qualität aufweist, dass ein Mittenrauhwert von 0,05 - 0,25 µm auf wenigstens einer Oberfläche der äußeren Schicht erreicht wird. Die Schwindung erfolgt nahezu nur in axialer Richtung.

Der erzeugte Schichtverbund ist schematisch in Fig. 1 skizziert, wobei die Metallisierung zur Vereinfachung weggelassen wurde.

Die Sintertemperaturen der Gießfolien A und B unterscheiden sich wenigstens um 30-40 K, vorzugsweise um 50 K, bevorzugter um 100 K und mehr, um die erfindungsgemäße geringe laterale Schwindung zu erzielen

Das Laminieren der Grünfolien wird vorzugsweise isostatisch Unter Verwendung von sogenannten Inserts durchgeführt, um Kavitäten (cavaties), Kanäle und Durchbrüche mit geringen Tole ranzen in den Schichtverbund integrieren zu können. Infolge der geringen lateralen Schwindung bleiben diese Toleranzen auch nach dem Sintern geringer als bei herkömmlichen Verfahren.

Die Metallisierung wenigstens der zweiten Grünfolie erfolgt allgemein durch übliches Aufbringen von metallischen Leiterbahnen. Das Einbringen von vertikalen Leiterbahnen (vias) erfolgt für alle Grünfolien.

Die Grünfolien werden durch Foliengießen aus einem Schlicker hergestellt. Der Schlicker enthält neben üblichen Hilfsstoffen zur Schlickerherstellung ein Rohstoffgemenge aus 40-90 Vol.-% eines Glaspulvers, vorzugsweise 60 bis 80 Vol.-%, und 60-10 Vol.-% eines keramischen Pulvers. Das Rohstoffgemenge kann weitere Zuschlagstoffe enthalten, wie übliche Farbkörper und Keimbildner.

Als Glaspulver im Verfahren wird ein Glas auf Basis von Alkaliborosilicatgläsern Me₂^{I}O-B₂O₃-SiO₂ oder Alumosilicatgläsern Me^{II}O-Al₂O₃-SiO₂ (Me^{II}=Ca,Ba,Zn) oder Alumoborosilicat-gläsern Me^{II}O-Al₂O₃-B₂O₃-SiO₂ oder Lanthan-Borat-Titanat-Gläsern (Me^{II}O)-La₂O₃-S₂O₃-TiO₂ oder Erdalkali-Lanthan-Borat-Gläsern (Me₂^{I}O)-Me^{II}O-La₂O₃-B₂O₃ worin Me^{I} = Li, Na, K und Gemische davon, sowie Me^{II} = Mg, Ca, Sr, Ba oder Zn, und Gemische davon sind, oder Gemische dieser Gläser eingesetzt. Die Auswahl wird nach üblichen, dem Fachmann auf diesem Gebiet bekannten Prinzipien durchgeführt, um entweder ein gewünschtes Kristallisationsverhalten bei den entsprechenden Temperaturen oder eine Kristallisationsstabilität des Glases zu erhalten. Das gleiche betrifft das Mischungsverhältnis mit den zugesetzten keramischen Pulvern.

Als keramische Pulver werden oxidische Stoffe, nitridische Stoffe oder Gemische davon eingesetzt, vorzugsweise Al₂O₃, AIN, Mg₂SiO₄, SiO₂, TiO₂, Zn₂SiO₄, ZrO₂, ZrSiO₄, Celsian, Mullit, Spodumen, Titanaten, Zirkonaten und Gemische davon.

Die Erfindung soll nachstehend durch Beispiele näher erläutert werden. In der dazugehörigen Zeichnung zeigen:
Fig. 1: einen keramischen Körper (Mehrlagenplatte) mit monolithischem Schichtaufbau,
Fig. 2: Diagramm der lateralen Schwindung als Funktion der Temperatur der LTCC-Werkstoffe von Beispiel 1,
Fig. 3: Diagramm der Schwindungsraten als Funktion der Temperatur der LTCC-Werkstoffe von Beispiel 1,
Fig. 4: Diagramm der lateralen Schwindung als Funktion der Temperatur der LTCC-Werkstoffe von Beispiel 2.
Fig. 5: Diagramm der Schwindungsraten als Funktion der Temperatur der LTCC-Werkstoffe von Beispiel 2
Fig. 6: Diagramm der lateralen Schwindung als Funktion der Temperatur der LTCC-Werkstoffe von Beispiel 3.
Fig. 7: Diagramm der Schwindungsraten als Funktion der Temperatur der LTCC-Werkstoffe von Beispiel 3

### Ausführungsbeispiel 1

Auf folgende Weise wird ein keramischer Körper, der sich durch einen monolithischen Mehrschichtaufbau und eine glasur-artige Brennhaut auszeichnet, hergestellt. Der Körper ist aufgebaut wie in Fig. 1 gezeigt und hergestellt aus den keramischen Folien A und B. Die Grünfolie B enthält kristallisierende Glasphase und sintert zwischen 650 und 800 °C. Die Grünfolie A enthält kristallisationsstabile Glasphase und sintert zwischen 800 und 910 °C. Der Körper hat mindestens eine Oberfläche mit einer glasigen Brennhaut mit hoher Oberflächenqualität.

### a) Herstellung der keramischen Grünfolie für die äußeren Schichten des keramischen Körpers

Aus 72 Vol.-% eines kommerziellen Pulvers aus Kaliumborosilicatglas A1 (gemäß Tabelle 1) und 28 Vol.-% eines kommerziellen kristallinen Pulvers aus Korund (gemäß Tabelle 2) wird durch gemeinsames Mahlen (Trocken- und Nassmahlung) und anschließende Sprühtrocknung ein Pulvergemisch hergestellt, dessen Partikelgrößen unter 3,5 µm vorliegen, charakterisiert durch einen D₅₀-Wert von 0,60 µm und einen D₉₀-Wert von 1,93 µm. Die Partikelgröße wird hier wie im folgenden jeweils mittels Laserstreulichtmethode unter Verwendung eines "Mastersizer S" der Fa. Malvern nach DIN EN 725-5 von 3/1996 bestimmt. Aus dem Pulver wird durch Zusatz kommerzieller Lösungs-/Dispergiermittel, Bindemittel, Weichmacher und Dispergatoren ein homogener Gießschlicker hergestellt. Dieser Schlicker wird mittels Doctor-Blade-Verfahren in einer Netzsch-Foliengießanlage Typ 355.70 zu einer keramischen Folie vergossen, deren Dicke nach dem Trocknen beispielsweise 140 µm beträgt. Diese keramische Grünfolie A zeichnet sich durch folgende Eigenschaften aus:

Die organischen Hilfsstoffe der Grünfolie können durch langsames Erhitzen bis 600°C vollständig ausgetrieben werden. In Fig. 2 und 3 ist das Sinterverhalten dieses Werkstoffs (Kurve 2) charakterisiert. Eine uniaxial gepresste Probe aus der o.g. Pulvergemisch wurde hierzu kontinuierlich mit 10 K/min aufgeheizt und der Verlauf der lateralen Schwindung und die Schwindungsrate als Funktion der Temperatur dilatometrisch aufgezeichnet. Bei diesem dynamischen Sinterversuch in einem Hochtemperaturdilatometer Typ 802-S der Firma Bähr GmbH beginnt die Schwindung bei ca. 750 °C und endet bei ca. 950 °C. Das Maximum der Schwindungsrate liegt bei 850 °C.

Einzelschichten oder Laminate einer entsprechenden Gießfolie können nach dem Austreiben der organischen Bestandteile bei 900 °C und einer Haltedauer von 10 min dicht gesintert werden. Das bedeutet, dieser Werkstoff, hier als BAM-LTCC 160 bezeichnet (siehe Tabelle 3), besitzt eine Dichtbrandtemperatur (= Sintertemperatur T_{S}) von 900°C. Die röntgenografische Phasenanalyse des gesinterten Schichtverbundes zeigt nur Korund und Glas, also ist keine Kristallisation der Glasphase beim Sintern und Abkühlen eingetreten. Die gesinterten Substrate besitzen eine glasige Brennhaut, die sich durch eine geringe Rauheit Rₐ: 0,12 µm, Rₜ : 1,5 µm und Welligkeit Wₜ: < 5 µm/cm auszeichnet. Die chemische Resistenz dieses LTCC-Substrates erwies sich bei den nasschemischen Prozessen der fotolithografischen Strukturierung im Rahmen der Dünnfilm-Beschichtung deutlich besser als die herkömmlicher LTCC-Produkte. Definition der Kenngrößen zur Oberflächenbeschaffenheit Rₐ (Mittenrauhwert), Wₜ (Wellentiefe) und Rₜ (Maximale Rauhtiefe): in DIN EN ISO 4287 von 10/1998 "Geometrische Produktspezifikation (GPS) - Oberflächenbeschaffenheit: Tastschnittverfahren - Benennungen, Definitionen und Kenngrößen der Oberflächenbeschaffenheit". Bestimmung der Oberflächenkennwerte Rₐ, Rₜ und Wₜ mittels Tastschnittverfahren gemäß DIN EN ISO 4288 von 4/1998 unter Verwendung eines Hommel-Testers T2000 der Hommelwerke GmbH.

Die Folien BAM-LTCC 160 werden zum Aufbau der Außenschichten des keramischen Körpers eingesetzt.

### b) Herstellung der keramischen Grünfolien für die inneren Schichten des keramischen Körpers

Aus 60 Vol.-% eines Calcium-Lanthan-Boratglases B1 (gemäß Tabelle 1) und 40 Vol.-% eines kommerziellen kristallinen Pulvers aus Korund (gemäß Tabelle 2) wird durch gemeinsames Mahlen ein Pulvergemisch hergestellt, dessen Partikelgröße unter 10 µm vorliegt. Aus dem Pulver wird durch Zusatz kommerzieller Lösungs-/Dispergiermittel, Bindemittel, Weichmacher und Dispergatoren ein homogener Gießschlicker hergestellt. Dieser Schlicker wird mittels Doctor-Blade-Verfahren in einer Netzsch-Foliengießanlage Typ 355.70 zu einer keramischen Folie vergossen, deren Dicke nach dem Trocknen beispielsweise 140 µm beträgt. Diese keramische Grünfolie B zeichnet sich durch folgende Eigenschaften aus:
Die organischen Hilfsstoffe der Grünfolie können durch langsames Erhitzen bis 600°C vollständig ausgetrieben werden. In den Abb. 1 und 2 ist das Sinterverhalten dieses Werkstoffs (Kurve 1) charakterisiert. Eine uniaxial gepresste Probe aus der o.g. Pulvergemisch wurde hierzu kontinuierlich mit 10 K/min aufgeheizt und der Verlauf der lateralen Schwindung und die Schwindungsrate als Funktion der Temperatur dilatometrisch aufgezeichnet. Bei diesem dynamischen Sinterversuch in einem Hochtemperaturdilatometer Typ 802-S der Firma Bähr GmbH beginnt die Schwindung bei ca. 625 °C und endet bei ca. 725 °C. Das Maximum der Schwindungsrate liegt bei 690 °C.

Bei 730, 785 und 875 °C werden mittels Differential-Thermoanalyse (Aufheizrate 5 K/min) Kristallisationsvorgänge beobachtet. Die röntgenografische Phasenanalyse zeigt bei Proben, die 10 min bei 900 °C getempert wurden, Lanthanborat (Hoch-LaBO₃) und Calciumalumoborat (CaAl₂B₂O₇).

Einzelschichten oder Laminate der entsprechenden Gießfolien können nach dem Austreiben der organischen Hilfsstoffe bei 700 °C und 10 min Haltedauer dicht gesintert werden. Bei einer anschließenden Temperaturerhöhung tritt keine weitere Schwindung auf, aber es erfolgt die erwünschte Bildung der oben genannten kristallinen Phasen, die erheblich zur Refiringstabilität des Schichtverbundes beitragen.

Die hier genannte Folie CLB/K (siehe Tab. 3) wird zum Aufbau der Innenschichten des keramischen Körpers eingesetzt.

In Fig. 2 ist die laterale Schwindung als Funktion der Temperatur der LTCC-Werkstoffe dieses Beispiels 1 dargestellt.
Darin zeigt die Kurve 1 einen LTCC-Werkstoff CLB/K zum Aufbau der inneren Schichten, und die Kurve 2 einen LTCC-Werkstoff BAM-LTCC 160 zum Aufbau der äußeren Schichten des keramischen Körpers(dynamische Dilatometerkurven, Heizrate 10 K/min).
In Fig. 3 sind die Schwindungsraten als Funktion der Temperatur der LTCC-Werkstoffe dieses Ausführungsbeispiels 1 dargestellt. Die Kurve 1 zeigt den LTCC-Werkstoff CLB/K zum Aufbau der inneren Schichten, die Kurve 2 den LTCC-Werkstoff BAM-LTCC 160 zum Aufbau der äußeren Schichten des keramischen Körpers (dynamische Dilatometerkurven, Heizrate 10 K/min).

### c) Formschneiden und Einbringen der Durchkontaktierungslöcher (vias)

### d) Metallisierung der Grünfolien und Befüllen der Durchkontaktierungslöcher (vias)

Die einzelnen Folienteile werden mit kommerziellen Pasten auf Silber-Basis (TC 7303 der Firma Heraeus GmbH & Co. KG, Hanau, Deutschland) bedruckt (Siebdruck) und die Durchkontaktierungslöcher mit Kontaktierungspasten (TC 7301, Heraeus; Deutschland) befüllt.

### e) Stapeln und Laminieren der keramischen Grünfolien

Als Beispiel werden je ein ausgestanztes Folienteil der keramischen Grünfolie BAM-LTCC 160 für die untere und oberste Schicht des Mehrlagenverbundes und zwei ausgestanzte Folienteile der keramischen Grünfolie CLB/K für die inneren Schichten übereinander gestapelt. Der Stapel wird in einer uniaxialen Presse bei 70 °C, einem Druck von 26 MPa und 10 min Haltezeit laminiert.

### f) Austreiben der organischen Hilfsstoffe

Der Grünkörper wird in einem Entbinderungsofen LK-312 der Firma Linn High Therm in einem Luftstrom mit einer Rate von 2 K/min auf 600 °C aufgeheizt und 20 min gehalten.

### g) Sintern/Co-firing des Laminates

Der entbinderte Grünkörper wird in einem Sinterofen PEO-601 der Firma ATV Technik GmbH mit 10 K/min auf 700 °C aufgeheizt und 30 min gehalten. Anschließend erfolgt ein weiteres Aufheizen mit 2 K/min auf 900 °C. Bei 900 °C wird die Temperatur 30 min gehalten. Es erfolgt anschließend ein Abkühlen mit 10 K/min auf Raumtemperatur. Die laterale Schwindung des Körpers beträgt 1,2 %, wobei die Schwindung in x-und y-Richtung gleich ist (zero-x/y-Schwindung). Die Standardabweichung σ der lateralen Schwindung beträgt 0,012 %, daraus ergibt sich eine Schwindungstoleranz 3σ von 0,036 % sowie eine Positionstoleranz T_{P} von 1,08 mils (1 mil = 10⁻³ Zoll) bzw. 27,4 µm für das hergestellte Substrat im 3-Zoll-Format. (Positionstoleranz T_{P} = 3σ x Format /100%)

Der erzeugte keramischer Körper zeichnet sich durch einen monolithischen Mehrschichtaufbau und eine glasurartige Brennhaut aus. Die äußere Schicht des Verbundes (Dicke: ca. 100 µm) zeigt keine Wasseraufnahme und besitzt eine relative Dichte von 99 %. Die offene Porosität ist Null. Die lichtmikroskopische Untersuchung des Gefüges mit bildanalytischer Auswertung zeigt eine Restporosität von 0,2 %. Die Oberfläche des keramischen Körpers weist die gleichen Eigenschaften wie gesintertes BAM-LTCC 160 auf. Die gesinterten Substrate besitzen eine glasige Brennhaut, die sich durch eine geringe Rauheit: Rₐ = 0,12 µm, Rₜ = 1,5 µm und Welligkeit: Wₜ < 5 µm/cm auszeichnet. Die chemische Resistenz des keramischen Körpers ermöglicht einen problemlosen nasschemischen Dünnfilmprozess zur Außenstrukturierung.

### Ausführungsbeispiel 2

Auf folgende Weise wird ein keramischer Körper, der sich durch einen monolithischen Mehrschichtaufbau und eine glasurartige Brennhaut auszeichnet, hergestellt:

### a) Herstellung der keramischen Grünfolie für die äußeren Schichten des keramischen Körpers

Aus 70 Vol.-% eines kommerziellen Pulvers aus Barium-Alumoborosilicatglas A2 (gemäß Tabelle 1) und 30 Vol.-% eines kommerziellen kristallinen Pulvers aus ZrSiO₄ (gemäß Tabelle 2) wird durch gemeinsames Mahlen (Trocken- und Nassmahlung) und anschließendes Sprühtrocknen ein Pulvergemisch hergestellt, dessen Partikelgrößen unter 3,5 µm vorliegen, charakterisiert durch einen D₅₀-Wert von 0,92 µm, einen D₉₀-Wert von 1,92 µm und einen D₉₇-Wert von 2,9 µm. Aus dem Pulver wird durch Zusatz kommerzieller Lösungs-/Dispergiermittel, Bindemittel, Weichmacher und Dispergatoren ein homogener Gießschlicker hergestellt. Dieser Schlicker wird mittels Doctor-Blade-Verfahren in einer Netzsch-Foliengießanlage Typ 355.70 zu einer keramischen Folie vergossen, deren Dicke nach dem Trocknen beispielsweise 130 µm beträgt.

Diese keramische Grünfolie A zeichnet sich durch folgende Eigenschaften aus:

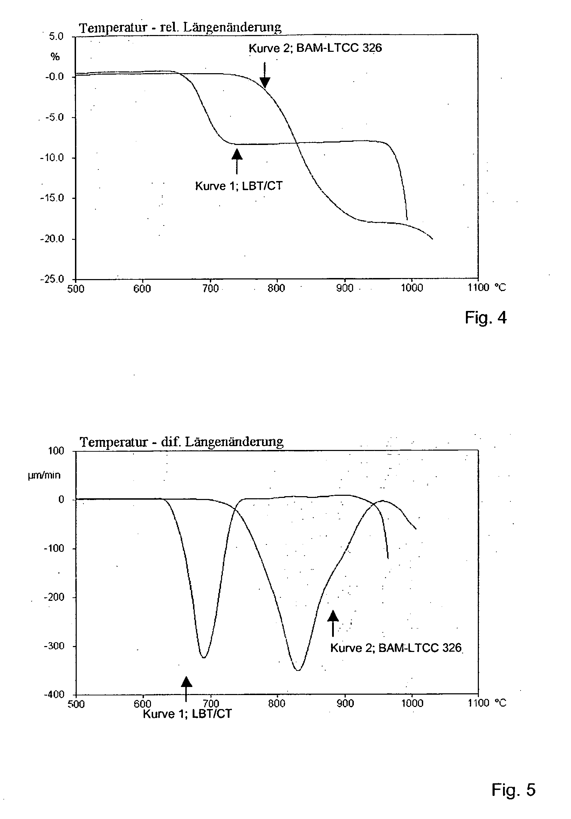

Die organischen Hilfsstoffe der Grünfolie können durch langsames Erhitzen bis 600°C vollständig ausgetrieben werden. In Fig. 4 und 5 ist das Sinterverhalten dieses Werkstoffs (Kurve 2) charakterisiert. Eine uniaxial gepresste Probe aus dem o.g. Pulvergemisch wurde hierzu kontinuierlich mit 10 K/min aufgeheizt und der Verlauf der lateralen Schwindung und die Schwindungsrate als Funktion der Temperatur dilatometrisch aufgezeichnet. Bei diesem dynamischen Sinterversuch in einem Hochtemperaturdilatometer Typ 802-S der Firma Bähr GmbH beginnt die Schwindung bei ca. 720 °C und endet bei ca. 910 °C. Das Maximum der Schwindungsrate tritt bei 830 °C auf.

Einzelschichten oder Laminate einer entsprechenden Gießfolie können nach dem Austreiben der organischen Bestandteile bei 875 °C und einer Haltedauer von 10 min dicht gesintert werden. Das bedeutet, dieser Werkstoff, hier als BAM-LTCC 326 bezeichnet, besitzt eine Dichtbrandtemperatur (= Sintertemperatur T_{S}) von 875 °C. Die röntgenografische Phasenanalyse des gesinterten Schichtverbundes zeigt nur Zirkon und Glas, also ist **keine** Kristallisation der Glasphase beim Sintern eingetreten. Die gesinterten Substrate besitzen eine glasige Brennhaut, die sich durch eine geringe Rauheit Rₐ: 0,2 µm, Rₜ: 2,0 µm und Welligkeit Wₜ: < 5 µm/cm auszeichnet. Die chemische Resistenz dieses LTCC-Substrates erwies sich bei den nasschemischen Prozessen der fotolithografischen Strukturierung im Rahmen der Dünnfilm-Beschichtung deutlich besser als die herkömmlicher LTCC-Produkte.

Die Folien BAM-LTCC 326 werden zum Aufbau der Außenschichten des keramischen Körpers eingesetzt.

### b) Herstellung der keramischen Grünfolien für die inneren Schichten des keramischen Körpers

Aus 65 Vol.-% eines Glases B2 aus dem Zusammensetzungsbereich La₂O₃-B₂O₃-TiO₂ (gemäß Tabelle 1) und 35 Vol.-% eines kommerziellen kristallinen Pulvers aus CaTiO₃ (gemäß Tabelle 2) wird durch gemeinsames Mahlen ein Pulvergemisch hergestellt, dessen Partikelgröße unter 10 µm vorliegt. Aus dem Pulver wird durch Zusatz kommerzieller Lösungs-/Dispergiermittel, Bindemittel, Weichmacher und Dispergatoren ein homogener Gießschlicker hergestellt. Dieser Schlicker wird mittels Doctor-Blade-Verfahren in einer Netzsch-Foliengießanlage Typ 355.70 zu einer keramischen Folie vergossen, deren Dicke nach dem Trocknen beispielsweise 130 µm beträgt. Diese keramische Grünfolie B zeichnet sich durch folgende Eigenschaften aus:

Die organischen Hilfsstoffe der Grünfolie können durch langsames Erhitzen bis 600°C vollständig ausgetrieben werden. In Fig. 4 und 5 ist das Sinterverhalten dieses Werkstoffs (Kurve 1) charakterisiert. Eine uniaxial gepresste Probe aus dem o.g. Pulvergemisch wurde hierzu kontinuierlich mit 10 K/min aufgeheizt und der Verlauf der lateralen Schwindung und die Schwindungsrate als Funktion der Temperatur dilatometrisch aufgezeichnet. Bei diesem dynamischen Sinterversuch in einem Hochtemperaturdilatometer Typ 802-S der Firma Bähr GmbH beginnt die Schwindung bei ca. 670 °C und endet bei ca. 755 °C. Das Maximum der Schwindungsrate liegt bei 717 °C.

Die röntgenografische Phasenanalyse zeigt bei Proben, die 10 min bei 875 °C getempert wurden, Tieftemperatur-Lanthanborat, Rutil und Calciumtitanat.

Einzelschichten oder Laminate der entsprechenden Gießfolien können nach dem Austreiben der organischen Hilfsstoffe bei 720 °C und 10 min Haltedauer dicht gesintert werden. Bei einer anschließenden Temperaturerhöhung tritt keine weitere Schwindung auf, aber es erfolgt die erwünschte Bildung der oben genannten kristallinen Phasen, die erheblich zur Refiringstabilität des Schichtverbundes beitragen.

Die hier genannte Folie LBT/CT (s. Tab. 3) wird zum Aufbau der Innenschichten des keramischen Körpers eingesetzt.

In Fig 4 ist die laterale Schwindung als Funktion der Temperatur der LTCC-Werkstoffe des Ausführungsbeispiels 2 dargestellt. Darin zeigt die Kurve 1 den LTCC-Werkstoff LBT/CT zum Aufbau der inneren Schichten, und die Kurve 2 den LTCC-Werkstoff BAM-LTCC 326 zum Aufbau der äußeren Schichten des keramischen Körpers (dynamische Dilatometerkurven, Heizrate 10 K/min)

In Fig. 5 sind die Schwindungsraten als Funktion der Temperatur der LTCC-Werkstoffe von Beispiel 2 dargestellt. Darin zeigt die Kurve 1 den LTCC-Werkstoff LBT/CT zum Aufbau der inneren Schichten, und die Kurve 2 den LTCC-Werkstoff BAM-LTCC 326 zum Aufbau der äußeren Schichten des keramischen Körpers (dynamische Dilatometerkurven, Heizrate 10 K/min)

### c) Formschneiden und Einbringen der Durchkontaktierungslöcher (vias)

### d) Metallisierung der Grünfolien und Befüllen der Durchkontaktierungslöcher (vias)

Die einzelnen Folienteile werden mit kommerziellen Pasten auf Silber-Basis (TC 7303 Fa. Heraeus; Deutschland) bedruckt (Siebdruck) und die Durchkontaktierungslöcher mit Kontaktierungspasten (TC 7301. Fa. Heraeus, Deutschland) befüllt.

### e) Stapeln und Laminieren der keramischen Grünfolien

Als Beispiel werden je ein ausgestanztes Folienteil der keramischen Grünfolie BAM-LTCC 326 für die untere und oberste Schicht des Mehrlagenverbundes und zwei ausgestanzte Folienteile der keramischen Grünfolie LBT/CT für die inneren Schichten übereinander gestapelt.

Der Stapel wird in einer uniaxialen Presse bei 70 °C, einem Druck von 26 MPa und 10 min Haltezeit laminiert.

### f) Austreiben der organischen Hilfsstoffe

Der Grünkörper wird in einem Entbinderungsofen LK-312 der Firma Linn High Therm in einem Luftstrom mit einer Rate von 2 K/min auf 600 °C aufgeheizt und 20 min gehalten.

### g) Sintern/Co-firing des Laminates

Der entbinderte Grünkörper wird in einem Sinterofen PEO-601 der Firma ATV Technik GmbH mit 10 K/min auf 720 °C aufgeheizt und 10 min gehalten. Anschließend erfolgt ein weiteres Aufheizen mit 2 K/min auf 875 °C. Bei 875 °C wird die Temperatur 20 min gehalten. Es erfolgt anschließend ein Abkühlen mit 10 K/min auf Raumtemperatur. Die laterale Schwindung des Körpers beträgt 0,4 %, wobei die Schwindung in x- und y-Richtung gleich ist (zero-x/y-Schwindung). Die Standardabweichung σ der Schwindung beträgt
0,03 %, daraus ergibt sich eine Schwindungstoleranz 3σ von 0,09 % sowie eine Positionstoleranz T_{P} von 2,7 mils bzw. 68,6 µm für das hergestellte Substrat im 3-Zoll-Format (Positionstoleranz T_{P} = 3σ x Format / 100%).

Der erzeugte keramischer Körper zeichnet sich durch einen monolithischen Mehrschichtaufbau und eine glasurartige Brennhaut aus. Die äußere Schicht des Verbundes (Dicke ca. 100 µm) zeigt keine Wasseraufnahme und besitzt eine relative Dichte von 99 %. Die offene Porosität ist Null. Die lichtmikroskopische Untersuchung des Gefüges mit bildanalytischer Auswertung zeigt eine Restporosität von 0,5 %. Die Oberfläche des keramischen Körpers weist die gleichen Eigenschaften wie gesintertes BAM-LTCC 326 auf. Die gesinterten Substrate besitzen eine glasige Brennhaut, die sich durch eine geringe Rauheit: Rₐ= 0,2 µm, Rₜ= 2,0 µm und Welligkeit: Wₜ= < 5 µm/cm auszeichnet. Die chemische Resistenz des keramischen Körpers ermöglicht einen pro-blemlosen nasschemischen Dünnfilmprozess zur Außenstrukturierung.

### Ausführungsbeispiel 3

Es wird wie im Beispiel 1 gearbeitet mit folgenden Änderungen: a)Herstellung der keramischen Grünfolie für die äußeren Schichten des keramischen Körpers

Einsatzmaterial 75 Vol.-% kommerzielles Pulver Barium-Alumoboro-silicatglas A3 (gemäß Tabelle 1) und 25 Vol.-% Gemisch aus kommerziellen kristallinen Pulvern Mullit (10 Vol.%) und Korund (15 Vol.-%) (gemäß Tabelle 2); Pulvergemisch: Partikelgröße unter 3,5 µm ;D₅₀-Wert 0,98 µm, D₉₀-Wert 2,63 µm und D₉₇-Wert 3,35 µm. Daraus hergestellter Gießschlicker wird mittels Doctor-Blade-Verfahren zu keramischer Folie mit Nutzbreite 8 Zoll ver-gossen; Dicke nach dem Trocknen beispielsgemäß 110 µm ± 5 µm.

Eigenschaften der keramischen Grünfolie A:

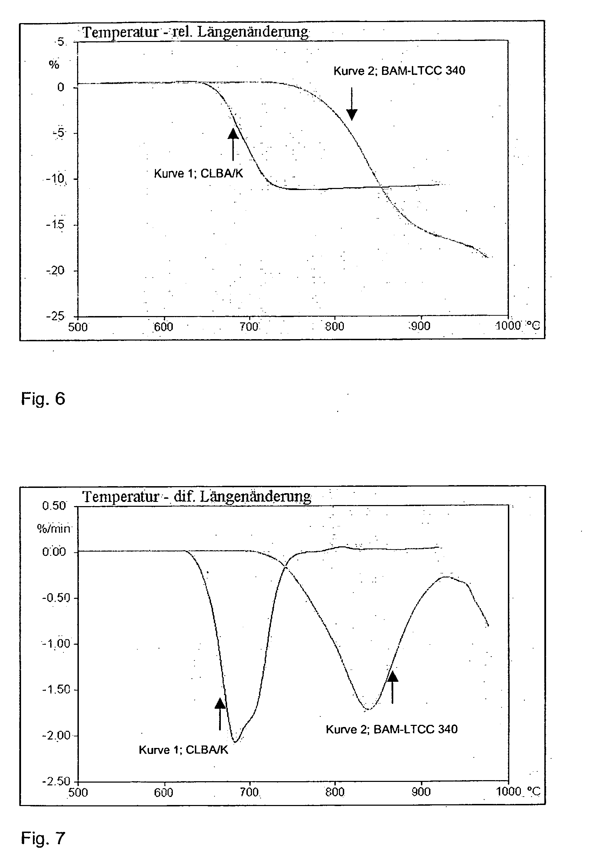

Die organischen Hilfsstoffe der Grünfolie können durch langsames Erhitzen bis 600°C vollständig ausgetrieben werden. In Fig. 6 und 7 ist das Sinterverhalten dieses Werkstoffs (Kurve 2) charakterisiert.

Uniaxial gepresste Probe im Sinterversuch: Schwindung beginnt bei ca. 700 °C und endet bei ca. 930 °C. Das Maximum der Schwindungsrate tritt bei 838 °C auf.

Einzelschichten oder Laminate einer entsprechenden Gießfolie können nach dem Austreiben der organischen Bestandteile bei 890 °C und einer Haltedauer von 10 min dicht gesintert werden. Das bedeutet, dieser Werkstoff, hier als BAM-LTCC 340 bezeichnet, besitzt eine Dichtbrandtemperatur (= Sintertemperatur Tₛᵢₙₜ) von 890 °C. Röntgenografische Phasenanalyse des gesinterten Schichtverbundes zeigt nur Korund, Mullit und Glas, also ist keine Kristallisation der Glasphase beim Sintern eingetreten. Die gesinterten Substrate besitzen eine glasige Brennhaut, die sich durch eine geringe Rauheit Rₐ: 0,14 µm, Rₜ: 2,1 µm und Welligkeit Wₜ: < 5 µm/cm auszeichnet. Die chemische Resistenz dieses LTCC-Substrates erwies sich bei den nasschemischen Prozessen der fotolithografischen Strukturierung im Rahmen der Dünnfilm-Beschichtung deutlich besser als die herkömmlicher LTCC-Produkte.

Die Folien BAM-LTCC 340 werden zum Aufbau der Außenschichten des keramischen Körpers eingesetzt.

### b) Herstellung der keramischen Grünfolien für die inneren Schichten des keramischen Körpers

Einsatzmaterial: 50 Vol.-% Calcium-Lanthan-Boratglases B3 (gemäß Tabelle 1) und 50 Vol.-% eines kommerziellen kristallinen Pulvers aus Korund (Al₂O₃) (gemäß Tabelle 2); Teilchengröße Pulvergemisch unter 10 µm. Daraus hergestellter Gießschlicker wird mittels Doctor-Blade-Verfahren zu einer keramischen Folie mit einer Nutzbreite von 8 Zoll vergossen; Dicke nach dem Trocknen 120 µm ± 5 µm.

Eigenschaften der Grünfolie B: Die organischen Hilfsstoffe der Grünfolie können durch langsames Erhitzen bis 600°C vollständig ausgetrieben werden. In Fig. 6 und 7 ist das Sinterverhalten dieses Werkstoffs (Kurve 1) charakterisiert. Uniaxial gepresste Probe (siehe Bsp. 1) im Sinterversuch: Schwindung beginnt bei ca. 623 °C und endet bei ca. 757 °C. Das Maximum der Schwindungsrate liegt bei 683 °C.

Die röntgenografische Phasenanalyse zeigt bei Proben, die 10 min bei 800 °C getempert wurden, Tieftemperatur-Lanthanborat, Calciumalumoborat und Korund. Dichtsintern von Einzelschichten oder Laminaten bei 700 °C und 10 min Haltedauer. Bei anschließender Temperaturerhöhung tritt keine weitere Schwindung auf, aber es erfolgt die erwünschte Bildung der oben genannten kristallinen Phasen, die erheblich zur Refiringstabilität des Schichtverbundes beitragen. Die genannte Folie CLBA/K (s. Tab. 3) wird zum Aufbau der Innenschichten des keramischen Körpers eingesetzt.

In Fig. 6 zeigt die Kurve 1 den LTCC-Werkstoff CLBA/K zum Aufbau der inneren Schichten, und die Kurve 2 den LTCC-Werkstoff BAM-LTCC 340 zum Aufbau der äußeren Schichten des keramischen Körpers (dynamische Dilatometerkurven, Heizrate 10 K/min).
In Fig. 7 zeigt die Kurve 1 den LTCC-Werkstoff CLBA/K zum Aufbau der inneren Schichten, und die Kurve 2 den LTCC-Werkstoff BAM-LTCC 340 zum Aufbau der äußeren Schichten des keramischen Körpers (dynamische Dilatometerkurven, Heizrate 10 K/min)

### c) Formschneiden und d) Metallisierung wie in Beispiel 1

### e) Stapeln und Laminieren der keramischen Grünfolien

Als Beispiel werden je zwei ausgestanzte Folienteile der keramischen Grünfolie BAM-LTCC 340 für die untere und oberste Schicht des Mehrlagenverbundes und zwei ausgestanzte Folienteile der keramischen Grünfolie CLBA/K für die inneren Schichten übereinander gestapelt; Laminieren wie im Beispiel 1.

### f) Austreiben der organischen Hilfsstoffe wie im Beispiel 1.

### g) Sintern/Co-firing des Laminates

Der entbinderte Grünkörper wird mit 5 K/min auf 700 °C aufgeheizt und 20 min gehalten; anschließend weiteres Aufheizen mit 5 K/min auf 890 °C. Bei 890 °C wird die Temperatur 20 min gehalten; Abkühlen mit 5 K/min auf Raumtemperatur. Die laterale Schwindung des Körpers beträgt 1,5 %, wobei die Schwindung in x- und y-Richtung gleich ist (zero-x/y-Schwindung). Die Standardabweichung σ der Schwindung beträgt 0,04 %, daraus ergibt sich eine Schwindungstoleranz 3σ von 0,12 % sowie eine Positionstoleranz T_{P} von 3,6 mils bzw. 91,4 µm für das hergestellte Substrat im 3-Zoll-Format (Positionstoleranz T_{P} = 3σ x Format / 100 %).
Der erzeugte keramischer Körper zeichnet sich durch einen monolithischen Mehrschichtaufbau und eine glasurartige Brennhaut aus. Die äußere Schicht des Verbundes (Dicke ca. 80 µm) zeigt keine Wasseraufnahme und besitzt eine relative Dichte von > 99 %. Die offene Porosität ist Null. Die lichtmikroskopische Untersuchung des Gefüges mit bildanalytischer Auswertung zeigt eine Restporosität von 0,2 %. Die Oberfläche des keramischen Körpers weist die gleichen Eigenschaften wie gesintertes BAM-LTCC 340 auf. Die gesinterten Substrate besitzen eine glasige Brennhaut, die sich durch eine geringe Rauheit: Rₐ= 0,14 µm, Rₜ= 2,1 µm und Welligkeit: Wₜ = < 5 µm/cm auszeichnet. Die chemische Resistenz des keramischen Körpers ermöglicht einen problemlosen nasschemischen Dünnfilmprozess zur Außenstrukturierung.

### Tabelle 1:

Zusammensetzung der Gläser in Gew.-% zur Herstellung von glaskeramischen Folien in den Ausführungsbeispielen 1, 2 und 3
A1: Alkaliborosilicatgläser Me₂^{I}O-B₂O₃-SiO₂
A2: Alumoborosilicatgläser Me^{II}O-Al₂O₃-B₂O₃-SiO₂
A3: Erdalkali-Alumo-Borosilicatgläser Me^{II}O-Al₂O₃-B₂O₃-SiO₂
B1: Erdalkali-Lanthan-Borat-Gläser (Me₂^{I}O)-Me^{II}O-La₂O₃-B₂O₃
B2: Lanthan-Borat-Titanat-Gläser (Me^{II}O)-La₂O₃-B₂O₃-TiO₂
B3: Erdalkali-Lanthan-Borat-Gläser

(Me₂^{I}O)-Me^{II}O-La₂O₃-(Al₂O₃)-B₂O₃

| Glas | SiO₂+Al₂O₃ | B₂O₃ | Li₂O+Na₂O+K₂O | MgO+CaO+SrO+Ba O | La₂O₃ | TiO₂ |
|---|---|---|---|---|---|---|
| A1 | 80 | 16,5 | 1,5 | 2 | - | - |
| A2 | 74 | 12 | - | 14 | - | - |
| A3 | 62 | 14 | 0,5 | 23,5 | - | - |
| B1 | - | 55 | 3 | 28 | 14 | - |
| B2 | - | 34 | - | 4 | 22 | 40 |
| B3 | 8 | 37 | - | 16 | 36 | 3 |

**Tabelle 2:**

| Ausgangsstoffe der kristallinen Komponenten zur Herstellung von glaskeramischen Folien in den Ausführungsbeispielen 1,2 und 3 | | |
|---|---|---|
| **Ausgangsstoff** | *Für die Außenschichten* | **Für die innere(n) Schicht(en)** |

| **Ausführungsbeispiel 1** | | |
|---|---|---|
| Al₂O₃ (Korund) | Calcinierte Tonerde der Firma Alcoa | Calcinierte Tonerde der Firma Alcoa CT 1200 |
| | CT 1200 und CT 3000 (1:1) | |

| **Ausführungsbeispiel 2** | | |
|---|---|---|
| CaTiO₃ (Calcium-titanat) | | Calciumtitanat-Pulver |
| | | CA 546010, elektronische Qualität, des Herstellers Goodfellow GmbH |
| ZrSiO₄ (Zirkon) | RZM Zirkonsand, Premium Grade, | |
| | des Herstellers Zirkon-Minerals GmbH | |

| **Ausführungsbeispiel 3** | | |
|---|---|---|
| Korund | Calcinierte Tonerde der Firma Alcoa | |
| | CT 1200 und CT 3000 (1:1) | |
| Mullit | Mullit Symulox M 72 der Firma Nabaltec GmbH | |
| Korund | | Martoxid M 23 der Firma Martinswerk GmbH |

**Tabelle 3:**

| Bezeichnung der in den Beispielen verwendeten Folien und deren Zusammensetzung (ohne organische Hilfsstoffe) | | | |
|---|---|---|---|
| Folie | | für Außenschichten | für Innenschichten |
| Beispiel 1 | Bezeichnung Zusammensetzung | BAM-LTCC 160 | CLB/K |
| | | 72 Vol.-% Glas A1 | 60 Vol.-% Glas B1 |
| | | 28 Vol.-% Al₂O₃ | 40 Vol.-% Al₂O₃ |
| | | (CT 1200/3000) | (CT 1200) |
| Beispiel 2 | Bezeichnung Zusammensetzung | BAM-LTCC 326 | LBT/CT |
| | | 70 Vol.-% Glas A2 | 65 Vol.-% Glas B2 |
| | | 30 Vol.-% ZrSiO₄ | 35 Vol.-% CaTiO₃ |
| Beispiel 3 | Bezeichnung Zusammensetzung | BAM-LTCC 340 | CLBA/K |
| | | 75 Vol.-% Glas A3 | 50 Vol.-% Glas B3 |
| | | 10 Vol.-% Al₂O₃-SiO₂ | 50 Vol.-% Al₂O₃ |
| | | (Mullit M72) | (M23) |
| | | 15 Vol.-% Al₂O₃ | |
| | | (CT 1200/3000) | |

## Patentansprüche

1. Verfahren zur Herstellung einer keramischen Mehrlagenplatte mit monolithischem Schichtaufbau, bestehend aus Innenlagen mit metallischen Leiterstrukturen und mit Durchkontaktierungen versehenen Außenlagen, wobei
(a) wenigstens zwei erste gegossene, keramische Grünfolien hergestellt werden, die jeweils Partikel eines Gemisches von 60-90 Vol-% Glaspulvern und 40-10 Vol-% kristallinen keramischen Pulvern mit Partikelgrößen im Bereich von 0,05 bis 3 µm umfassen mit einem Medianwert der Partikelgrößenverteilung D₅₀ von <1µm, wobei 90 % der Partikel eine Partikelgröße <2,63 µm haben, und wobei diese ersten Grünfolien eine Sintertemperatur von 800-910 °C haben,
(b) wenigstens eine zweite keramische Grünfolie hergestellt wird, die Partikel eines Gemisches von 40-70 Vol.-% eines Glaspulvers und 30-60 Vol.-% eines kristallinen keramischen Pulvers umfasst mit Partikelgrößen im Bereich von 0,05 bis 10 µm, und wobei die zweite Grünfolie eine Sintertemperatur von 650-800 °C hat, und nach dem lateralen Stapeln und Laminieren der ersten Folien und der zweiten Folien übereinander, wobei die ersten Folien jeweils die Außenlagen des erhaltenen Schichtverbundes bilden, der Schichtverbund einem ersten Sinterschritt im Temperaturbereich von 650-800 °C für einen Zeitraum von maximal 60 min unterworfen wird, bei der die zweite Grünfolie dicht sintert und kristallisiert, und anschließend einer zweiten Sintertemperatur im Bereich von 800-910 °C für einen Zeitraum von 10 min bis 60 min unterworfen wird, bei der die ersten Grünfolien dicht sintern und nicht kristallisieren, wobei sich die Sintertemperatur von Außen- und Innenlagen um wenigstens 50 K unterscheiden.

2. Verfahren nach Anspruch 1, **dadurch gekennzeichnet, dass** die metallischen Leiterstrukturen wenigstens der zweiten Grünfolie durch Aufbringen von Leiterbahnen und Einbringen von vertikalen Durchkontaktierungen gebildet werden.

3. Verfahren nach Anspruch 1, **dadurch gekennzeichnet, dass** das Gemisch weitere Zuschlagstoffe enthält, ausgewählt unter üblichen Farbkörpern für die ersten und zweiten Folien und Keimbildnern für die zweiten Folien.

4. Verfahren nach Anspruch 1, **dadurch gekennzeichnet, dass** die Sintertemperaturen der inneren und der äußeren Schichten sich um wenigstens 100 K unterscheiden.

5. Verfahren nach Anspruch 1, **dadurch gekennzeichnet, dass** ein Glaspulver eingesetzt wird, das ausgewählt ist unter
Alkaliborosilicatgläser Me₂^{I}O-B₂O₃-SiO₂,
Alumo-Borosilicatgläser Me^{II}O-Al₂O₃-B₂O₃-SiO₂,
Alumosilicatgläser Me^{II}O-Al₂O₃-SiO₂,
Erdalkali-Lanthan-Borat-Gläser (Me₂^{I}O)-Me^{II}O-La₂O₃- B₂O₃
Lanthan-Borat-Titanat-Gläser (Me^{II}O)-La₂O₃-B₂O₃-TiO₂
und Gemischen dieser Gläser,
worin Me^{I} = Li, Na, K oder mehrere davon sind, sowie Me^{II} = Mg, Ca, Sr, Ba, Zn oder mehrere davon sind.

6. Verfahren nach Anspruch 5, **dadurch gekennzeichnet, dass** als Glaspulver für die äußeren Folien
Alkali-Borosilicatgläser Me₂^{I}O-B₂O₃-SiO₂,
Alumo-Borosilicatgläser Me^{II}O-Al₂O₃-B₂O₃-SiO₂,
und Alumosilicatgläser Me^{II}O-Al₂O₃-SiO₂ und Gemische dieser Gläser eingesetzt werden, worin Me^{I} = Li, Na, K oder mehrere davon sind, sowie Me^{II} = Mg, Ca, Sr, Ba, Zn oder mehrere davon sind.

7. Verfahren nach Anspruch 1, **dadurch gekennzeichnet, dass** ein keramisches Pulver eingesetzt wird, das ausgewählt ist unter oxidischen Stoffen, nitridischen Stoffen und Gemischen dieser Stoffe, insbesondere unter Al₂O₃, AIN, Mg₂SiO₄, SiO₂, TiO₂, Zn₂SiO₄, ZrO₂, ZrSiO₄, Celsian, Mullit, Spodumen, Titanaten, Zirkonaten und Gemischen dieser Stoffe.

8. Verfahren nach Anspruch 7, **dadurch gekennzeichnet, dass** als keramische Pulver Al₂O₃, SiO₂, Mg₂SiO₄, Zn₂SiO₄, ZrSiO₄, Mullit, und Calciumtitanat allein oder als Gemisch von diesen eingesetzt wird/werden.

## Claims

1. A method for the production of a ceramic multi-layer sheet with a monolithic layer structure, consisting of inner layers with metallic conductor structures and outer layers provided with via-holes, wherein
(a) at least two first cast ceramic green films are produced, each one comprising particles of a mixture of 60-90% by volume glass powders and 40-10% by volume crystalline ceramic powders having particle sizes ranging from 0.05 to 3 µm, with a median value of the particle size distribution D₅₀ < 1 µm, with 90% of the particles having a particle size < 2.63 µm, and said first green films having a sinter temperature of 800-910°C,
(b) at least one second ceramic green film is produced, which comprises particles of a mixture of 40-70% by volume of a glass powder and 30-60% by volume of a crystalline ceramic powder having particle sizes ranging from 0.05 to 10 µm, said second green film having a sinter temperature of 650-800°C,
and, following lateral stacking and laminating the first films and second films one on top of the other, with the first films forming the outer layers of the resulting layer composite, said layer composite is subjected to a first sinter step in a temperature range of from 650 to 800°C for a period of 60 min at maximum, during which the second green film undergoes dense sintering and crystallization,
and is subsequently subjected to a second sinter temperature ranging from 800 to 910°C for a period of from 10 min to 60 min, during which the first green films undergo dense sintering without crystallization, the sinter temperatures of outer and inner layers differing by at least 50 K.

2. The method according to claim 1, **characterized in that** the metallic conductor structures of at least the second green film are formed by applying conductor tracks and incorporating vertical via-holes.

3. The method according to claim 1, **characterized in that** the mixture includes further additives selected from standard coloring materials for the first and second films and nucleating agents for the second films.

4. The method according to claim 1, **characterized in that** the sinter temperatures of the inner and outer layers differ by at least 100 K.

5. The method according to claim 1, **characterized in that** a glass powder is used, selected from
alkali borosilicate glasses Me₂^{I}O-B₂O₃-SiO₂,
alumoborosilicate glasses Me^{II}O-Al₂O₃-B₂O₃-SiO₂,
alumosilicate glasses Me^{II}O-Al₂O₃-SiO₂,
alkaline earth-lanthanum-borate glasses (Me₂^{I}O)-Me^{II}O-La₂O₃-B₂O₃,
lanthanum-borate-titanate glasses (Me^{II}O)-La₂O₃-B₂O₃-TiO₂,
and mixtures of the above glasses,
wherein Me^{I} = Li, Na, K or a plurality thereof, and Me^{II} = Mg, Ca, Sr, Ba, Zn or a plurality thereof.

6. The method according to claim 5, **characterized in that** alkali borosilicate glasses Me₂^{I}O-B₂O₃-SiO₂,
alumoborosilicate glasses Me^{II}O-Al₂O₃-B₂O₃-SiO₂,
alumosilicate glasses Me^{II}O-Al₂O₃-SiO₂ and mixtures of these glasses are used as glass powders for the outer films, wherein Me^{I} = Li, Na, K or a plurality thereof, and Me^{II} = Mg, Ca, Sr, Ba, Zn or a plurality thereof.

7. The method according to claim 1, **characterized in that** a ceramic powder is used, which is selected among oxide materials, nitride materials and mixtures of these materials, particularly among Al₂O₃, AlN, Mg₂SiO₄, SiO₂, TiO₂, Zn₂SiO₄, ZrO₂, ZrSiO₄, celsian, mullite, spodumene, titanates, zirconates and mixtures of these materials.

8. The method according to claim 7, **characterized in that** Al₂O₃, SiO₂, Mg₂SiO₄, Zn₂SiO₄, ZrSiO₄, mullite, and calcium titanate, alone or as mixture thereof, is/are used as ceramic powders.

## Revendications

1. Procédé de fabrication d'une plaque céramique multi-couche avec une structure de couches monolithique, se composant de couches internes à structures métalliques conductrices et avec des couches externes munies de connexions transversales,
dans lequel :
a) on fabrique au moins deux feuilles brutes céramiques coulées en premier, lesquelles comprennent chacune des particules d'un mélange de 60-90 % en volume de poudres de verre et 40-10 % en volume de poudres céramiques cristallines avec des tailles de particules comprises dans la plage allant de 0,05 à 3 µm, avec une valeur moyenne de granulométrie des particules D₅₀ < 1 µm, au moins 90 % des particules ayant une taille < 2,63 µm et ces premières feuilles brutes ayant une température de frittage de 800-910°C.
b) on fabrique au moins une deuxième feuille céramique brute, qui comprend des particules d'un mélange de 40-70 % en volume d'une poudre de verre et 30-60 % en volume d'une poudre céramique cristalline avec des tailles de particules dans la plage allant de 0,05 à 10 µm et la deuxièmes feuille brute ayant une température de frittage de 650-800°C,
et après l'empilement latéral et le laminage des premières feuilles et des deuxièmes feuilles les unes sur les autres, les premières feuilles formant respectivement les couches externes de l'association de couches obtenue, l'association de couches étant soumise à une première étape de frittage dans la plage de températures de 650-800°C pour une durée de maximum 60 min, au cours de laquelle la deuxième feuille brute s'agglomère par frittage de manière dense et se cristallise,
pour être ensuite soumise à une deuxième température de frittage dans la plage de 800-910°C pour une durée de 10 à 60 min, au cours de laquelle les premières feuilles brutes s'agglomèrent par frittage de manière dense et ne se cristallisent pas, la température de frittage des couches externes et la température de frittage des couches internes étant distinctes d'au moins 50 K.

2. Procédé selon la revendication 1, **caractérisé en ce que** les structures métalliques conductrices d'au moins la deuxième feuille brute sont formées par l'application de bandes conductrices et la mise en place de connexions transversales verticales.

3. Procédé selon la revendication 1, **caractérisé en ce que** le mélange contient d'autres adjuvants choisis parmi des corps colorants habituels pour les premières et deuxièmes feuilles et des agents de nucléation pour les deuxièmes feuilles.

4. Procédé selon la revendication 1, **caractérisé en ce que** les températures de frittage des couches internes et externes sont distinctes d'au moins 100 K.

5. Procédé selon la revendication 1, **caractérisé en ce qu'**on utilise une poudre de verre qui est choisie parmi :
- les verres de borosilicate alcalin Me₂^{I}O-B₂O₃-SiO₂
- les verres de borosilicate d'aluminium Me^{II}O-Al₂O₃-B₂O₃-SiO₂
- les verres d'aluminosilicate Me^{II}O-Al₂O₃-SiO₂
- les verres de borate-lanthane-alcalino-terreux (Me₂^{I}O)-Me^{II}O-La₂O₃-B₂O₃
- les verres de titanate-lanthane-borate (Me^{II}O)-La₂O₃-B₂O₃-TiO₂
et les mélanges de ces verres,
où Me^{I} = Li, Na, K ou correspond à plusieurs d'entre eux, et Me^{II} = Mg, Ca, Sr, Ba, Zn ou correspond à plusieurs d'entre eux.

6. Procédé selon la revendication 5, **caractérisé en ce qu'**on utilise comme poudre de verre pour les feuilles externes :
- des verres de borosilicate alcalin Me₂^{I}O-B₂O₃-SiO₂
- des verres de borosilicate d'aluminium Me^{II}O-Al₂O₃-B₂O₃-SiO₂
- des verres d'aluminosilicate Me^{II}O-Al₂O₃-SiO₂
et les mélanges de ces verres, où Me^{I} = Li, Na, K ou correspond à plusieurs d'entre eux, et Me^{II} = Mg, Ca, Sr, Ba, Zn
ou correspond à plusieurs d'entre eux.

7. Procédé selon la revendication 1, **caractérisé en ce qu'**on utilise une poudre céramique qui est choisie parmi des substances oxydées, des nitrures et leurs mélanges, en particulier parmi l'Al₂O₃, l'AIN, le Mg₂SiO₄, le SiO₂, le TiO₂, le Zn₂SiO₄, le ZrO₂, le ZrSiO₄, la celsiane, la mullite, le spodumène, les titanates, les zirconates et leurs mélanges.

8. Procédé selon la revendication 7, **caractérisé en ce qu'**on utilise comme poudre céramique du Al₂O₃, du SiO₂, du Mg₂SiO₄, du Zn₂SiO₄, du ZrSiO₄, de la mullite et du titanate de calcium, seuls ou mélangés.
